# DEMANDE DE BREVET EUROPEEN

(11) **EP 1 764 805 A1**
(43) Date de publication de la demande: **21.03.2007**
(21) Numéro de dépôt: 06018168.2
(22) Date de dépôt: 31.08.2006
(51) Int. Cl.: G11C 16/34

(54) **Procédé de vérification de l'effacement par bloc d'une mémoire**

(30) Priorité: 08.09.2005 FR 0509142
(71) Demandeur: STMicroelectronics SA, 92120 Montrouge (FR)
(72) Inventeur: Naura, David, 13100 Aix en Provence (FR); Moreaux, Christophe, 13109 Simiane (FR); Kari, Ahmed, 13100 Aix en Provence (FR); Rizzo, Pierre, 13100 Aix en Provence (FR)
(74) Mandataire: Marchand, André

(57) **Abrégé**

L'invention concerne un procédé de vérification de l'état d'un ensemble de cellules mémoire d'une mémoire comprenant des cellules mémoire (MC) agencées dans un plan mémoire (MA), des moyens de sélection (RDEC, CDEC) d'une cellule mémoire, et un circuit de lecture (SA) pour fournir un état de la cellule mémoire sélectionnée selon que la cellule mémoire sélectionnée est conductrice ou non conductrice. Le procédé selon l'invention comprend des étapes au cours desquelles toutes les cellules mémoire d'un ensemble regroupant plusieurs cellules mémoire sont sélectionnées, puis connectées simultanément au circuit de lecture (SA), et le circuit de lecture fournit un état global de toutes les cellules mémoire sélectionnées auxquelles il est connecté, si celles-ci sont simultanément non conductrices. Application à la vérification d'une commande d'effacement par bloc d'une mémoire.

## Description

La présente invention concerne les mémoires dans lesquelles chaque cellule mémoire présente un état programmé ou effacé selon que la cellule mémoire est conductrice ou non.

La présente invention concerne plus particulièrement une mémoire effaçable et programmable, comprenant des cellules mémoire agencées dans un plan mémoire, des moyens de sélection d'une cellule mémoire, et un circuit de lecture pour fournir l'état de la cellule mémoire sélectionnée.

En particulier, dans une mémoire EEPROM, les cellules mémoire sont agencées selon des lignes de mot et selon des colonnes de bit transversales aux lignes de mot. Les cellules mémoire d'une colonne de bit sont connectées à une ligne de bit commune. La mémoire comprend en outre un décodeur de ligne pour sélectionner une ligne de mot, un décodeur de colonne pour sélectionner une ligne de bit, et des transistors de sélection commandés par le décodeur de colonne pour connecter le circuit de lecture à une ligne de bit sélectionnée.

Chaque cellule mémoire comprend un transistor à grille flottante connecté en série avec un transistor d'accès de type MOS. Le transistor à grille flottante comprend une grille flottante et une grille de contrôle CG formée sur la grille flottante.

Toutes les cellules mémoire d'un bloc regroupant tout ou partie des cellules mémoire de la mémoire peuvent être effacées simultanément en plaçant la grille de contrôle de tous les transistors à grille flottante du bloc à un certain potentiel. La vérification de cette opération implique la lecture de toutes les cellules mémoire du bloc effacé.

Or la lecture d'une cellule mémoire est effectuée en sélectionnant la cellule mémoire et en la connectant à un circuit de lecture. Comme la mémoire ne comporte qu'un nombre limité de circuits de lecture, cette opération de vérification nécessite un nombre de cycles de lecture au moins égal au nombre de cellules mémoire à vérifier, divisé par le nombre de circuits de lecture. En outre, si toutes les cellules mémoire effacées sont connectées à une même ligne de bit, un seul circuit de lecture peut être utilisé. Par conséquent, le nombre de cycles de lecture nécessaires à la vérification de chacune des cellules mémoire effacées est égal au nombre de cellules mémoire à vérifier.

Lorsque le nombre de cellules mémoire effacées simultanément est important, la vérification d'une telle opération d'effacement n'est pas envisageable.

La présente invention a pour but de réaliser une vérification de l'état effacé d'un bloc de cellules mémoire en un cycle de lecture.

Cet objectif est atteint par la prévision d'un procédé de vérification de l'état d'un ensemble de cellules mémoire d'une mémoire comprenant des cellules mémoire agencées dans un plan mémoire, des moyens de sélection d'une cellule mémoire, et un circuit de lecture pour fournir un état de la cellule mémoire sélectionnée selon que la cellule mémoire sélectionnée est conductrice ou non conductrice.

Selon l'invention, le procédé comprend des étapes consistant à :
- sélectionner toutes les cellules mémoire d'un ensemble regroupant plusieurs cellules mémoire,
- connecter le circuit de lecture simultanément à toutes les cellules mémoire sélectionnées, et
- fournir par le circuit de lecture un état global de toutes les cellules mémoire sélectionnées auxquelles il est connecté, si celles-ci sont toutes simultanément non conductrices.

Selon un mode de réalisation de l'invention, les cellules mémoire sont agencées dans le plan mémoire selon des lignes de mot et selon des colonnes de bit transversales aux lignes de mot, les cellules mémoire d'une colonne de bit étant connectées à une ligne de bit commune, le procédé comprenant des étapes consistant à :
- sélectionner simultanément plusieurs lignes de mot,
- sélectionner une ligne de bit, et
- connecter le circuit de lecture à la ligne de bit sélectionnée, de manière à le connecter simultanément à toutes les cellules mémoire connectées à la ligne de bit sélectionnée et appartenant aux lignes de mot sélectionnées.

Selon un mode de réalisation de l'invention, les cellules mémoire sont agencées dans le plan mémoire selon des lignes de mot et selon des colonnes de bit transversales aux lignes de mot, les cellules mémoire d'une colonne de bit étant connectées à une ligne de bit commune, le procédé comprenant des étapes consistant à :
- sélectionner au moins une ligne de mot,
- sélectionner plusieurs lignes de bit, et
- connecter le circuit de lecture aux lignes de bit sélectionnées, de manière à le connecter simultanément à toutes les cellules mémoire connectées aux lignes de bit sélectionnées et appartenant aux lignes de mot sélectionnées.

Selon un mode de réalisation de l'invention, les cellules mémoire sont agencées dans le plan mémoire selon des lignes de mot et selon des colonnes de bit transversales aux lignes de mot, les cellules mémoire d'une colonne de bit étant connectées à une ligne de bit commune, les lignes de bits étant regroupées en colonnes de mot comportant m lignes de bits, m étant un nombre entier supérieur à 1, la mémoire comportant m circuits de lecture, le procédé comprenant des étapes consistant à :
- sélectionner plusieurs lignes de mot,
- sélectionner toutes les lignes de bit d'une colonne de mot, et
- connecter chaque circuit de lecture à une ligne de bit sélectionnée, de sorte que chaque circuit de lecture est connecté aux cellules mémoire connectées à la ligne de bit et appartenant aux lignes de mot sélectionnées.

Selon un mode de réalisation de l'invention, les cellules mémoire sont agencées dans le plan mémoire selon des lignes de mot et selon des colonnes de bit transversales aux lignes de mot, les cellules mémoire d'une colonne de bit étant connectées à une ligne de bit commune, les lignes de bits étant regroupées en colonnes de mot comportant m lignes de bits, m étant un nombre entier supérieur à 1, la mémoire comportant m circuits de lecture, le procédé comprenant des étapes consistant à :
- sélectionner au moins une ligne de mot,
- sélectionner toutes les lignes de bit de plusieurs colonnes de mot sélectionnées, et
- connecter chaque circuit de lecture à une ligne de bit de chaque colonne de mot sélectionnée, de sorte que chaque circuit de lecture est connecté aux cellules mémoire connectées à plusieurs lignes de bit et appartenant aux lignes de mot sélectionnées.

Selon un mode de réalisation de l'invention, toutes les cellules mémoire de la mémoire sont sélectionnées et connectées simultanément à un circuit de lecture.

L'invention concerne également un procédé d'effacement d'un bloc de cellules mémoire d'une mémoire comprenant un plan mémoire dans lequel sont agencées des cellules mémoire, et au moins un circuit de lecture pour lire une cellule mémoire sélectionnée, le procédé comprenant des étapes consistant à :
- sélectionner les cellules mémoire à effacer, et
- effacer les cellules mémoire sélectionnées en les plaçant à l'état non conducteur.

Selon l'invention, le procédé d'effacement comprend une étape de vérification de l'état des cellules mémoire effacées conformément au procédé de vérification tel que défini ci-avant.

L'invention concerne également une mémoire comprenant :
- des cellules mémoire agencées dans un plan mémoire,
- des moyens de sélection pour sélectionner des cellules mémoire,
- un circuit de lecture pour déterminer si une cellule mémoire sélectionnée à laquelle il est connecté est conductrice ou non conductrice, et
- des moyens de commutation pour connecter une cellule mémoire sélectionnée au circuit de lecture.

Selon l'invention, les moyens de sélection et de commutation permettent de sélectionner simultanément plusieurs cellules mémoires et de les connecter au circuit de lecture, le circuit de lecture fournissant un état global de toutes les cellules mémoire sélectionnées auxquelles il est connecté, si celles-ci sont toutes simultanément non conductrices.

Selon un mode de réalisation de l'invention, les cellules mémoire sont agencées dans le plan mémoire selon des lignes de mot et selon des colonnes de bit transversales aux lignes de mot, les cellules mémoire d'une colonne de bit étant connectées à une ligne de bit commune, la mémoire comprenant :
- un décodeur de ligne pour sélectionner une ou simultanément plusieurs lignes de mot,
- un décodeur de colonne pour sélectionner une ligne de bit, et
- des moyens de commutation commandés par le décodeur de colonne pour connecter le circuit de lecture à une ligne de bit sélectionnée.

Selon un mode de réalisation de l'invention, les cellules mémoire sont agencées dans le plan mémoire selon des lignes de mot et selon des colonnes de bit transversales aux lignes de mot, les cellules mémoire d'une colonne de bit étant connectées à une ligne de bit commune, la mémoire comprenant :
- un décodeur de ligne pour sélectionner une ou simultanément plusieurs lignes de mot,
- un décodeur de colonne pour sélectionner une ou simultanément plusieurs lignes de bit, et
- des moyens de commutation commandés par le décodeur de colonne pour connecter le circuit de lecture à toutes lignes de bit sélectionnées.

Selon un mode de réalisation de l'invention, les cellules mémoire sont agencées dans le plan mémoire selon des lignes de mot et selon des colonnes de bit transversales aux lignes de mot, les cellules mémoire d'une colonne de bit étant connectées à une ligne de bit commune, les colonnes de bit étant regroupées en colonnes de mot comportant m+1 lignes de bits, m étant un nombre entier supérieur à 0, la mémoire comprenant :
- un décodeur de ligne pour sélectionner simultanément plusieurs lignes de mot,
- un décodeur de colonne pour sélectionner une colonne de mot,
- m+1 circuits de lecture, et
- un transistor de sélection pour chaque ligne de bit d'une colonne de mot, chaque transistor étant commandé par le décodeur de colonne pour connecter chaque circuit de lecture à une ligne de bit de la colonne de mot sélectionnée.

Selon un mode de réalisation de l'invention, les cellules mémoire sont agencées dans le plan mémoire selon des lignes de mot et selon des colonnes de bit transversales aux lignes de mot, les cellules mémoire d'une colonne de bit étant connectées à une ligne de bit commune, les colonnes de bit étant regroupées en colonnes de mot comportant m+1 lignes de bits, m étant un nombre entier supérieur à 0, la mémoire comprenant :
- un décodeur de ligne pour sélectionner une ou simultanément plusieurs lignes de mot,
- un décodeur de colonne pour sélectionner simultanément plusieurs colonnes de mot,
- m+1 circuits de lecture, et
- un transistor de sélection pour chaque ligne de bit d'une colonne de mot, chaque transistor étant commandé par le décodeur de colonne pour connecter chaque circuit de lecture à une ligne de bit de chaque colonne de mot sélectionnée.

Selon un mode de réalisation de l'invention, toutes les cellules mémoire de la mémoire sont sélectionnées et connectées simultanément à un circuit de lecture.

Selon un mode de réalisation de l'invention, chaque cellule mémoire comprend un transistor à grille flottante agencé en série avec un transistor d'accès dont la grille est connectée à une ligne de sélection commune aux cellules mémoire appartenant à une même ligne de mot, et dont le drain est connecté à une ligne de bit commune aux cellules mémoire appartenant à une même ligne de bit, les lignes de sélection étant connectées au décodeur de ligne.

Selon un mode de réalisation de l'invention, la mémoire est effaçable et programmable électriquement.

L'invention concerne également un circuit intégré comprenant un microprocesseur, et une mémoire telle que définie ci-avant, le microprocesseur comprenant des moyens pour commander la sélection, l'effacement et la vérification de l'effacement de simultanément plusieurs cellules mémoire de la mémoire.

Selon un mode de réalisation de l'invention, le circuit intégré est une puce RFID.

Ces objets, caractéristiques et avantages ainsi que d'autres de la présente invention seront exposés plus en détail dans la description suivante de l'invention, faite à titre non limitatif en relation avec les figures jointes parmi lesquelles :
- la figure 1 représente l'architecture d'une mémoire EEPROM à un seul circuit de lecture, dans laquelle l'état effacé d'un bloc de cellules mémoire peut être vérifié selon l'invention ;
- la figure 2 représente l'architecture d'une mémoire EEPROM à plusieurs circuits de lecture, dans laquelle l'état effacé d'un bloc de cellules mémoire peut être vérifié selon l'invention ;
- la figure 3 représente l'architecture générale d'une mémoire à plusieurs circuits de lecture, dans laquelle l'état effacé d'un bloc de cellules mémoire peut être vérifié selon l'invention.

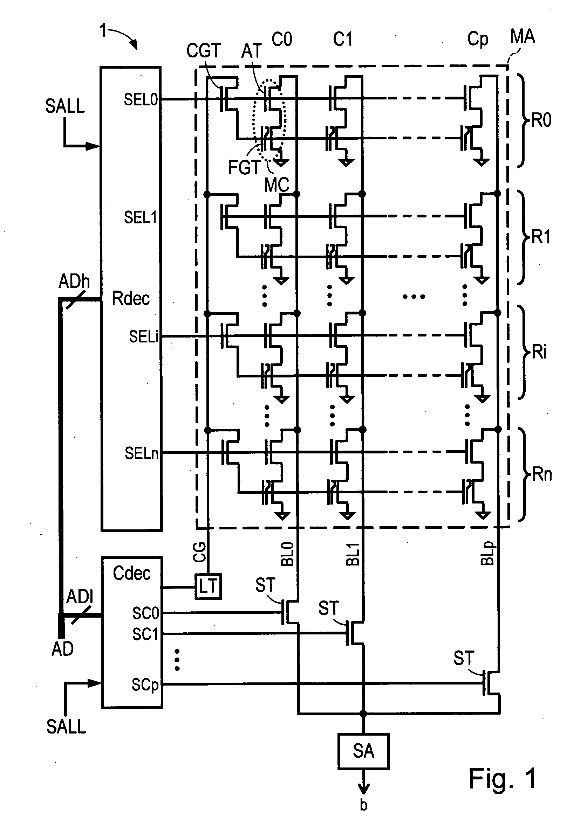

La figure 1 représente une mémoire EEPROM 1 comprenant un plan mémoire MA dans laquelle sont agencées des cellules mémoire MC, un décodeur de ligne RDEC, un décodeur de colonne CDEC et un circuit de lecture (sense amplifier) SA. La mémoire 1 peut donc mémoriser des mots binaires dont chaque bit qui est mémorisé par une cellule mémoire, ne peut être lu que séquentiellement. Une telle mémoire est par exemple utilisée dans les puces RFID.

Les cellules mémoire MC sont agencées dans le plan mémoire en lignes de mot Ri, i étant un nombre entier compris entre 0 et n, chaque colonne de bit comportant n+1 cellules mémoire. Les cellules mémoire sont également agencées en colonnes de bit Ck transversales aux lignes de mot, k étant un nombre entier compris entre 0 et p, chaque ligne de mot comportant p+1 cellules mémoire.

Chaque ligne de mot Ri comprend une ligne de sélection SELi connectée au décodeur de ligne RDEC et aux cellules mémoire de la ligne de mot. Chaque ligne de mot comprend en outre un transistor de contrôle de grille CGT dont la grille est commandée par la ligne de sélection SELi. Chaque colonne de bit Ck comprend une ligne bit BLk connectée aux cellules mémoire MC de la colonne de bit. Une ligne de contrôle de grille CG relie le drain des transistors de contrôle de grille CGT à la sortie d'un verrou LT commandé par le décodeur de colonne CDEC. Chaque ligne de bit est connectée au drain d'un transistor de sélection ST dont la grille est commandée par le décodeur de colonne. A cet effet, la grille du transistor de sélection ST de chaque colonne de bit est connectée au décodeur de colonne par une ligne de sélection de colonne SCk. Les sources des transistors ST sont connectées à l'entrée du circuit de lecture SA.

Le décodeur de ligne RDEC reçoit en entrée les bits de poids fort ADh d'une adresse AD de la mémoire, tandis que le décodeur de colonne CDEC reçoit les bits de poids faible AD1 de l'adresse AD.

Chaque cellule mémoire MC comprend un transistor d'accès AT monté en série avec un transistor à grille flottante FGT. La source du transistor FGT est connectée à la masse. La grille du transistor AT est connectée à la ligne de sélection SELi de la ligne de mot Ri à laquelle la cellule mémoire appartient. La grille des transistors FGT d'une ligne de mot Ri est connectée à la source du transistor CGT commun aux cellules mémoire de la ligne de mot. Le drain du transistor AT est connecté à la ligne de bit BLk de la colonne de bit Ck.

Le fonctionnement d'une telle cellule-mémoire est basé sur l'effet tunnel (ou effet Fowler-Nordheim) et consiste à induire des déplacements de la tension de seuil du transistor à grille flottante FGT en injectant ou en retirant des charges de sa grille flottante au travers d'une fine couche d'oxyde séparant la grille flottante de la zone en silicium dopé formant le transistor. Une opération d'effacement ou de programmation d'une cellule mémoire consiste à injecter ou extraire des charges électriques par effet Fowler-Nordheim dans la grille flottante du transistor FGT. Le transistor FGT présente une tension de seuil VT1 (par exemple égale à environ -2 V) à l'état programmé, et une tension de seuil VT2 (par exemple égale à environ 4 V) à l'état effacé supérieure à la tension VT1. Lorsqu'une tension de lecture Vread comprise entre VT1 et VT2 est appliquée par l'intermédiaire du transistor CGT, sur la grille de contrôle du transistor FGT, celui-ci reste bloqué s'il est effacé, ce qui correspond par convention à un "0" logique, et est passant s'il est programmé, ce qui correspond à un "1" logique. Bien entendu, une convention inverse peut être retenue.

La sélection d'une cellule mémoire appartenant à la ligne de mot Ri et à la colonne de bit Ck est effectuée en appliquant des tensions prédéfinies sur la ligne de sélection SELi de la ligne de mot Ri, et sur la ligne de sélection de colonne SCk de la colonne de bit Ck. Le verrou LT est commandé pour débloquer le transistor CGT d'une ligne de mot Ri. En lecture, la sélection d'une colonne de bit Ck a notamment pour effet de débloquer le transistor ST et donc de connecter au circuit de lecture SA la ligne de bit BLk connectée à la cellule mémoire sélectionnée. La sortie du circuit de lecture SA fournit un signal binaire b représentatif de l'état conducteur ou non conducteur de la cellule mémoire MC sélectionnée.

Selon l'invention, les décodeurs de ligne RDEC et de colonne CDEC permettent de sélectionner en lecture plusieurs cellules mémoire, et de connecter simultanément toutes les cellules mémoire MC sélectionnées au circuit de lecture SA. Si toutes les cellules mémoire connectées au circuit de lecture sont non conductrices (effacées), le circuit de lecture détecte un état non conducteur (effacé) et donc fournit un "0" logique. Ce signal est représentatif de l'état effacé de toutes les cellules mémoire sélectionnées. Par contre, si une ou plusieurs des cellules mémoire sélectionnées sont conductrices (programmées), le circuit de lecture fournit un "1" logique. Le signal de sortie b du circuit de lecture SA indique donc si une opération précédente d'effacement d'un ensemble de cellules mémoire a réussi ou échoué. Toutefois, si le signal b est à "1", il ne permet pas de déterminer quelles cellules mémoire sélectionnées sont effacées et celles qui sont programmées.

Les cellules mémoire connectées au circuit de lecture SA peuvent être sélectionnées de différentes manières. Ainsi, toutes les lignes de mot Ri ou seulement certaines peuvent être sélectionnées, tandis qu'une seule ligne de bit BLk est connectée au circuit de lecture. Alternativement, toutes les lignes de bit ou seulement certaines peuvent être connectées au circuit de lecture, tandis qu'une ou plusieurs lignes de mot sont sélectionnées.

Selon un mode de réalisation de l'invention, les décodeurs de ligne RDEC et de colonne CDEC comprennent chacun une entrée de commande SALL pour sélectionner en lecture toutes les cellules mémoire de la mémoire 1. De cette manière, toutes les cellules mémoire de la mémoire peuvent être sélectionnées en effacement, puis en lecture pour vérification de l'effacement.

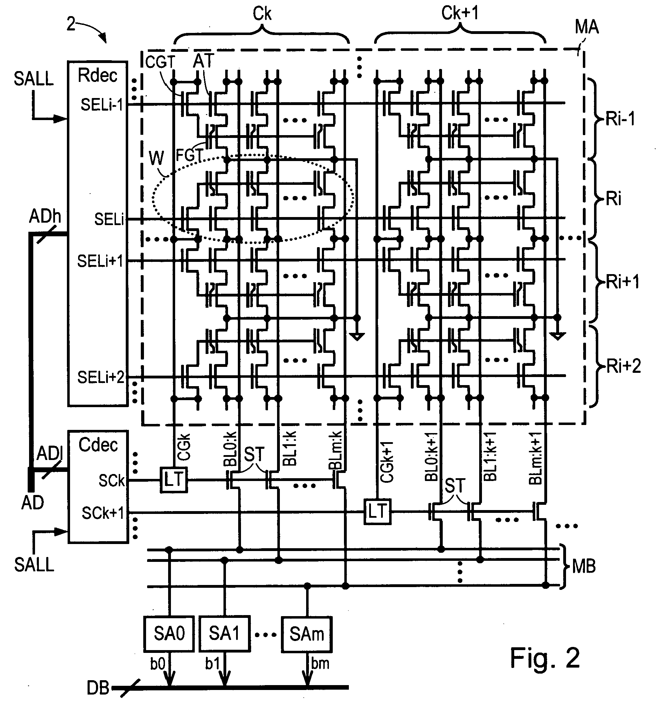

La figure 2 représente une mémoire EEPROM 2 à m+1 circuits de lecture SA0-SAm (m étant un nombre entier supérieur à 0), pour lire simultanément tous les bits d'un mot binaire à m+1 bits mémorisé dans la mémoire. Comme dans la figure 1, la mémoire 2 comprend un plan mémoire MA dans laquelle les cellules mémoire MC sont agencées en lignes de mot Ri et en colonnes bit transversales aux lignes de mot comportant chacune une ligne de bit BLj:k connectée aux cellules mémoire de la colonne de bit (j étant un nombre entier compris entre 0 et m). Les colonnes de bit sont regroupées en colonnes de mot comprenant m+1 colonnes de bit. Chaque intersection d'une ligne de mot Ri et d'une colonne de mot Ck définit ainsi un groupe W de m+1 cellules mémoire formant un mot.

Chaque ligne de mot Ri comprend une ligne de sélection SELi connectée au décodeur de ligne RDEC et aux cellules mémoire de la ligne de mot. Chaque colonne de mot Ck comprend une ligne de commande de grille CGk connectée au drain de transistors de contrôle de grille CGT, chaque transistor CGT étant commun aux cellules mémoire MC d'un groupe W. Chaque ligne de contrôle de grille est connectée à un verrou LT commun à chaque colonne de mot, et commandé par le décodeur de colonne CDEC.

Chaque ligne de bit BLj:k est connectée au drain d'un transistor de sélection ST dont la grille est commandée par le décodeur de colonne CDEC. Le verrou LT et les transistors de sélection ST de chaque colonne de mot Ck sont connectés au décodeur de colonne CDEC par une ligne de sélection de colonne SCk. La source de chacun des transistors ST dont le drain est connecté à la ligne de bit BLj:k est connectée à l'entrée d'un circuit de lecture SAj par l'intermédiaire d'un bus de multiplexage MB.

Le décodeur de ligne RDEC reçoit en entrée les bits de poids fort ADh d'une adresse AD de la mémoire, tandis que le décodeur de colonne CDEC reçoit les bits de poids faible AD1 de l'adresse AD.

Chaque cellule mémoire MC comprend un transistor d'accès AT monté en série avec un transistor à grille flottante FGT. La source du transistor FGT est connectée à la masse. Dans un groupe de cellules mémoire formant un mot W, c'est-à-dire appartenant à une même ligne de mot Ri et une même colonne de mot Ck, la grille des transistors FGT est connectée à la source du transistor CGT commun aux cellules mémoire du mot W. Les grilles des transistors AT et CGT d'une ligne de mot Ri sont connectées à la ligne de sélection SELi de la ligne de mot.

La sélection d'un groupe W de cellules mémoire appartenant à une ligne de mot Ri et une colonne de mot Ck est effectuée en appliquant des tensions prédéfinies sur la ligne de sélection SELi de la ligne de mot Ri, et sur la ligne de sélection SCk de la colonne de mot Ck, pour commander les verrous LT et les transistors de sélection ST de cette colonne de mot. En lecture, la sélection d'une colonne de mot Ck a pour effet de connecter à un circuit de lecture SAj chaque ligne de bit BLj:k de la colonne de mot Ck auxquelles appartiennent les cellules mémoire sélectionnées. Chaque circuit de lecture SAj applique sur un bus DB un signal binaire bj représentatif de l'état conducteur ou non conducteur d'une cellule mémoire MC sélectionnée à laquelle il est connecté.

Selon l'invention, les décodeurs de ligne RDEC et de colonne CDEC permettent de sélectionner en lecture plusieurs groupes W de cellules mémoire, et de connecter simultanément tous les groupes W de cellules mémoire sélectionnés aux circuits de lecture SAj. Comme précédemment décrit en référence à la figure 1, chaque circuit de lecture est ainsi connecté simultanément à plusieurs cellules mémoire sélectionnées. A cet effet, toutes les lignes de mot Ri ou seulement certaines peuvent être sélectionnées, tandis qu'une seule colonne de mot Ck est sélectionnée. Il en résulte que chaque ligne de bit BLj:k de la colonne de mot sélectionnée est connectée à un circuit de lecture SAj. Alternativement, toutes les lignes de bit ou seulement certaines peuvent être connectées à un circuit de lecture, tandis qu'une ou plusieurs lignes de mot sont sélectionnées.

Comme précédemment décrit en référence à la figure 1, les décodeurs de ligne RDEC et de colonne CDEC peuvent avantageusement comprendre chacun une entrée de commande SALL pour sélectionner en lecture toutes les cellules mémoire de la mémoire 2. De cette manière, l'exécution d'une commande d'effacement de toutes les cellules mémoire de la mémoire peut être vérifiée.

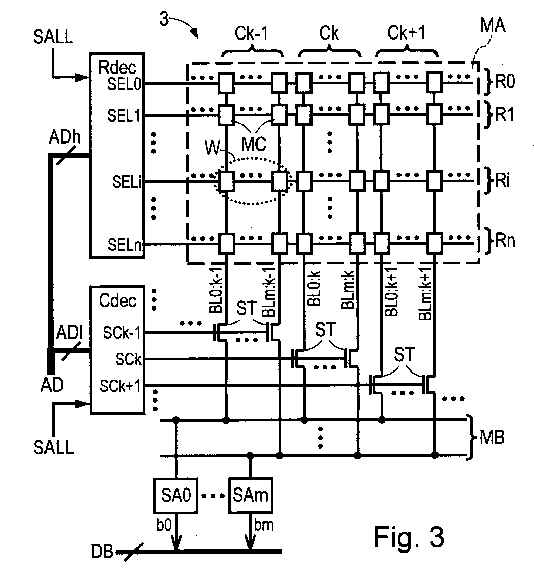

Il apparaîtra clairement à l'homme de l'art que la mémoire selon l'invention est susceptible de diverses variantes. Ainsi, comme illustré sur la figure 3, l'invention ne s'applique pas nécessairement à une mémoire EEPROM, mais à toute mémoire dans laquelle les cellules mémoire sont passantes ou non passantes selon leur état programmé ou effacé. La mémoire 3 représentée sur la figure 3 comprend un plan mémoire MA dans laquelle les cellules mémoire MC sont agencées en lignes de mot Ri et en colonnes bit transversales aux lignes de mot comportant chacune une ligne de bit BLj:k connectée aux cellules mémoire de la colonne de bit. Les colonnes de bit sont regroupées en colonnes de mot Ck comprenant 1 à m+1 colonnes de bit, m+1 étant le nombre de circuits de lecture SA0-SAm de la mémoire.

Chaque ligne de mot Ri comprend une ligne de sélection SELi connectée au décodeur de ligne RDEC et aux cellules mémoire de la ligne de mot. Chaque ligne de bit BLj:k est connectée au drain d'un transistor de sélection ST dont la grille est commandée par le décodeur de colonne CDEC. A cet effet, la grille du transistor de sélection ST de chaque colonne de mot Ck est connectées au décodeur de colonne CDEC par une ligne de sélection de colonne SCk. La source de chacun des transistors ST dont le drain est connecté à la ligne de bit BLj:k est connectée à l'entrée d'un circuit de lecture SAj (j étant un nombre entier compris entre 0 et m) par l'intermédiaire d'un bus de multiplexage MB.

Le décodeur de ligne RDEC reçoit en entrée les bits de poids fort ADh d'une adresse AD de la mémoire, tandis que le décodeur de colonne CDEC reçoit les bits de poids faible AD1 de l'adresse AD.

La sélection d'un groupe W de cellules mémoire appartenant à une ligne de mot Ri et une colonne de mot Ck dans la mémoire 3 est effectuée en appliquant des tensions prédéfinies sur la ligne dé sélection SELi de la ligne de mot Ri, et sur la ligne de sélection SCk de la colonne de mot Ck, pour commander les transistors de sélection ST de cette colonne de mot. En lecture, la sélection d'une colonne de mot Ck a pour effet de connecter chaque ligne de bit BLj:k de la colonne de mot Ck sélectionnée à un circuit de lecture SAj. Chaque circuit de lecture SAj fournit sur un bus DB un signal binaire bj représentatif de l'état conducteur ou non conducteur d'une cellule mémoire MC du groupe de, cellules mémoire sélectionné à laquelle il est connecté.

Selon l'invention, les décodeurs de ligne RDEC et de colonne CDEC permettent de sélectionner en lecture plusieurs groupes W de cellules mémoire, et de connecter simultanément tous les groupes W de cellules mémoire sélectionnés aux circuits de lecture SA0-SAm. Comme précédemment décrit en référence à la figure 2, chaque circuit de lecture est ainsi connecté simultanément à plusieurs cellules mémoire sélectionnées. A cet effet, toutes les lignes de mot Ri ou seulement certaines peuvent être sélectionnées, tandis qu'une seule colonne de mot Ck est sélectionnée, c'est-à-dire que chaque ligne de bit BLj:k de la colonne de mot Ck sélectionnée est connectée à un circuit de lecture SA0-SAm. Alternativement, toutes les lignes de bit ou seulement certaines peuvent être connectées à un circuit de lecture, tandis qu'une ou plusieurs lignes de mot sont sélectionnées.

Les décodeurs de ligne RDEC et de colonne CDEC peuvent également comprendre chacun une entrée de commande SALL pour sélectionner toutes les cellules mémoire de la mémoire 3, afin d'exécuter une commande d'effacement de la totalité de la mémoire, et d'en vérifier l'exécution.

Par ailleurs, il n'est pas nécessaire que les cellules mémoire de la mémoire soient réparties conformément à une structure matricielle en lignes et en colonnes. Il suffit que la mémoire comporte un ou plusieurs circuits de lecture et que chaque circuit de lecture puisse être connecté simultanément à plusieurs cellules mémoire sélectionnées.

## Revendications

1. Procédé de vérification de l'état d'un ensemble de cellules mémoire d'une mémoire comprenant des cellules mémoire (MC) agencées dans un plan mémoire (MA), des moyens de sélection (RDEC, CDEC) d'une cellule mémoire, et un circuit de lecture (SA, SA0-SAm) pour fournir un état de la cellule mémoire sélectionnée selon que la cellule mémoire sélectionnée est conductrice ou non conductrice,
**caractérisé en ce qu'**il comprend des étapes consistant à :
- sélectionner toutes les cellules mémoire d'un ensemble regroupant plusieurs cellules mémoire,
- connecter le circuit de lecture (SA, SA0-SAm) simultanément à toutes les cellules mémoire (MC) sélectionnées, et
- fournir par le circuit de lecture un état global de toutes les cellules mémoire sélectionnées auxquelles il est connecté, si celles-ci sont toutes simultanément non conductrices.

2. Procédé selon la revendication 1, dans lequel les cellules mémoire (MC) sont agencées dans le plan mémoire (MA) selon des lignes de mot (Ri) et selon des colonnes de bit transversales aux lignes de mot, les cellules mémoire d'une colonne de bit étant connectées à une ligne de bit (BLk) commune, le procédé comprenant des étapes consistant à :
- sélectionner simultanément plusieurs lignes de mot (Ri),
- sélectionner une ligne de bit, et
- connecter le circuit de lecture (SA) à la ligne de bit sélectionnée, de manière à le connecter simultanément à toutes les cellules mémoire connectées à la ligne de bit sélectionnée et appartenant aux lignes de mot sélectionnées.

3. Procédé selon la revendication 1, dans lequel les cellules mémoire (MC) sont agencées dans le plan mémoire (MA) selon des lignes de mot (Ri) et selon des colonnes de bit transversales aux lignes de mot, les cellules mémoire d'une colonne de bit étant connectées à une ligne de bit (BLk) commune, le procédé comprenant des étapes consistant à :
- sélectionner au moins une ligne de mot (Ri),
- sélectionner plusieurs lignes de bit, et
- connecter le circuit de lecture (SA) aux lignes de bit sélectionnées, de manière à le connecter simultanément à toutes les cellules mémoire connectées aux lignes de bit sélectionnées et appartenant aux lignes de mot sélectionnées.

4. Procédé selon la revendication 1, dans lequel les cellules mémoire (MC) sont agencées dans le plan mémoire (MA) selon des lignes de mot (Ri) et selon des colonnes de bit transversales aux lignes de mot, les cellules mémoire d'une colonne de bit étant connectées à une ligne de bit (BLj:k) commune, les lignes de bits étant regroupées en colonnes de mot (Ck) comportant m lignes de bits, m étant un nombre entier supérieur à 1, la mémoire comportant m circuits de lecture (SA0-SAm), le procédé comprenant des étapes consistant à :
- sélectionner plusieurs lignes de mot (Ri),
- sélectionner toutes les lignes de bit (BLj:k) d'une colonne de mot, et
- connecter chaque circuit de lecture à une ligne de bit sélectionnée, de sorte que chaque circuit de lecture est connecté aux cellules mémoire connectées à la ligne de bit et appartenant aux lignes de mot sélectionnées.

5. Procédé selon la revendication 1, dans lequel les cellules mémoire (MC) sont agencées dans le plan mémoire (MA) selon des lignes de mot (Ri) et selon des colonnes de bit transversales aux lignes de mot, les cellules mémoire d'une colonne de bit étant connectées à une ligne de bit (BLj:k) commune, les lignes de bits étant regroupées en colonnes de mot (Ck) comportant m lignes de bits, m étant un nombre entier supérieur à 1, la mémoire comportant m circuits de lecture (SA0-SAm), le procédé comprenant des étapes consistant à :
- sélectionner au moins une ligne de mot (Ri),
- sélectionner toutes les lignes de bit (BLj:k) de plusieurs colonnes de mot sélectionnées, et
- connecter chaque circuit de lecture à une ligne de bit de chaque colonne de mot sélectionnée, de sorte que chaque circuit de lecture est connecté aux cellules mémoire connectées à plusieurs lignes de bit et appartenant aux lignes de mot sélectionnées.

6. Procédé selon l'une des revendications 1 à 5, dans lequel toutes les cellules mémoire (MC) de la mémoire sont sélectionnées et connectées simultanément à un circuit de lecture (SA, SA0-SAm).

7. Procédé d'effacement d'un bloc de cellules mémoire d'une mémoire comprenant un plan mémoire (MA) dans lequel sont agencées des cellules mémoire (MC), et au moins un circuit de lecture (SA, SA0-SAm) pour lire une cellule mémoire sélectionnée, le procédé comprenant des étapes consistant à :
- sélectionner les cellules mémoire à effacer, et
- effacer les cellules mémoire sélectionnées en les plaçant à l'état non conducteur,
**caractérisé en ce qu'**il comprend une étape de vérification de l'état des cellules mémoire effacées conformément au procédé selon l'une des revendications 1 à 6.

8. Mémoire comprenant :
- des cellules mémoire (MC) agencées dans un plan mémoire (MA),
- des moyens de sélection (RDEC, CDEC, LT) pour sélectionner des cellules mémoire,
- un circuit de lecture (SA, SA0-SAm) pour déterminer si une cellule mémoire sélectionnée à laquelle il est connecté est conductrice ou non conductrice, et
- des moyens de commutation (ST) pour connecter une cellule mémoire sélectionnée au circuit de lecture,
**caractérisée en ce que** les moyens de sélection et de commutation (RDEC, CDEC, ST, LT) permettent de sélectionner simultanément plusieurs cellules mémoires et de les connecter au circuit de lecture (SA, SA0-SAm), le circuit de lecture fournissant un état global de toutes les cellules mémoire sélectionnées auxquelles il est connecté, si celles-ci sont toutes simultanément non conductrices.

9. Mémoire selon la revendication 8, dans lequel les cellules mémoire (MC) sont agencées dans le plan mémoire (MA) selon des lignes de mot (Ri) et selon des colonnes de bit (Ck) transversales aux lignes de mot, les cellules mémoire d'une colonne de bit étant connectées à une ligne de bit (BLk) commune, la mémoire comprenant :
- un décodeur de ligne (RDEC) pour sélectionner une ou simultanément plusieurs lignes de mot (Ri),
- un décodeur de colonne (CDEC) pour sélectionner une ligne de bit, et
- des moyens de commutation (ST) commandés par le décodeur de colonne pour connecter le circuit de lecture (SA) à une ligne de bit sélectionnée.

10. Mémoire selon la revendication 8, dans laquelle les cellules mémoire (MC) sont agencées dans le plan mémoire (MA) selon des lignes de mot (Ri) et selon des colonnes de bit (Ck) transversales aux lignes de mot, les cellules mémoire d'une colonne de bit étant connectées à une ligne de bit (BLk) commune, la mémoire comprenant :
- un décodeur de ligne (RDEC) pour sélectionner une ou simultanément plusieurs lignes de mot (Ri),
- un décodeur de colonne (CDEC) pour sélectionner une ou simultanément plusieurs lignes de bit, et
- des moyens de commutation (ST) commandés par le décodeur de colonne pour connecter le circuit de lecture (SA) à toutes lignes de bit sélectionnées.

11. Mémoire selon la revendication 8, dans laquelle les cellules mémoire (MC) sont agencées dans le plan mémoire (MA) selon des lignes de mot (Ri) et selon des colonnes de bit transversales aux lignes de mot, les cellules mémoire d'une colonne de bit étant connectées à une ligne de bit (BLj:k) commune, les colonnes de bit étant regroupées en colonnes de mot (Ck) comportant m+1 lignes de bits, m étant un nombre entier supérieur à 0, la mémoire comprenant :
- un décodeur de ligne (RDEC) pour sélectionner simultanément plusieurs lignes de mot (Ri),
- un décodeur de colonne (CDEC) pour sélectionner une colonne de mot,
- m+1 circuits de lecture (SA0-SAm), et
- un transistor de sélection (ST) pour chaque ligne de bit d'une colonne de mot, chaque transistor étant commandé par le décodeur de colonne pour connecter chaque circuit de lecture à une ligne de bit de la colonne de mot sélectionnée.

12. Mémoire selon la revendication 8, dans laquelle les cellules mémoire (MC) sont agencées dans le plan mémoire (MA) selon des lignes de mot (Ri) et selon des colonnes de bit transversales aux lignes de mot, les cellules mémoire d'une colonne de bit étant connectées à une ligne de bit (BLj:k) commune, les colonnes de bit étant regroupées en colonnes de mot (Ck) comportant m+1 lignes de bits, m étant un nombre entier supérieur à 0, la mémoire comprenant :
- un décodeur de ligne (RDEC) pour sélectionner une ou simultanément plusieurs lignes de mot (Ri),
- un décodeur de colonne (CDEC) pour sélectionner simultanément plusieurs colonnes de mot,
- m+1 circuits de lecture (SA0-SAm), et
- un transistor de sélection (ST) pour chaque ligne de bit d'une colonne de mot, chaque transistor étant commandé par le décodeur de colonne pour connecter chaque circuit de lecture à une ligne de bit de chaque colonne de mot sélectionnée.

13. Mémoire selon l'une des revendications 8 à 12, dans laquelle toutes les cellules mémoire (MC) de la mémoire sont sélectionnées et connectées simultanément à un circuit de lecture (SA, SA0-SAm).

14. Mémoire selon l'une des revendications 8 à 13, dans laquelle chaque cellule mémoire (MC) comprend un transistor à grille flottante (FGT) agencé en série avec un transistor d'accès (AT) dont la grille est connectée à une ligne de sélection (SELi) commune aux cellules mémoire appartenant à une même ligne de mot (Ri), et dont le drain est connecté à une ligne de bit (BLj:k) commune aux cellules mémoire appartenant à une même ligne de bit, les lignes de sélection étant connectées au décodeur de ligne (RDEC).

15. Mémoire effaçable et programmable électriquement selon l'une des revendications 8 à 14.

16. Circuit intégré comprenant un microprocesseur, **caractérisé en ce qu'**il comprend une mémoire selon l'une des revendications 8 à 15, le microprocesseur comprenant des moyens pour commander la sélection, l'effacement et la vérification de l'effacement de simultanément plusieurs cellules mémoire de la mémoire.

17. Circuit intégré selon la revendication 16, constitué par une puce RFID.
